# EUROPÄISCHE PATENTSCHRIFT

(11) **EP 1 393 378 B1**
(45) Veröffentlichungstag und Bekanntmachung des Hinweises auf die Patenterteilung: **15.09.2004**
(21) Anmeldenummer: 02758294.9
(22) Anmeldetag: 02.07.2002
(51) Int. Cl.: H01L 29/423, H01L 21/28

(54) **VERFAHREN ZUR ERZEUGUNG EINER STUFENFÖRMIGEN STRUKTUR AUF EINEM SUBSTRAT**
METHOD FOR PRODUCING A STEPPED STRUCTURE ON A SUBSTRATE
PROCEDE D'OBTENTION D'UNE STRUCTURE ETAGEE SUR UN SUBSTRAT

(30) Priorität: 02.07.2001 DE 10131917
(43) Veröffentlichungstag der Anmeldung: 03.03.2004
(73) Patentinhaber: Infineon Technologies AG, 81669 München (DE)
(72) Erfinder: HERZUM, Christian, 82343 Poecking (DE)
(74) Vertreter: Stöckeler, Ferdinand, Dipl.-Ing.
(86) Internationale Anmeldenummer: PCT/EP2002/007314
(87) Internationale Veröffentlichungsnummer: WO 2003/005411

(56) Entgegenhaltungen:
- EP-A- 0 399 527
- US-A- 4 803 179
- US-A- 4 868 136
- US-A- 5 254 489
- US-A- 5 801 416
- US-A- 6 150 220
- PATENT ABSTRACTS OF JAPAN vol. 014, no. 278 (E-0941), 15. Juni 1990 (1990-06-15) & JP 02 087675 A (RICOH CO LTD), 28. März 1990 (1990-03-28)

## Beschreibung

Die vorliegende Erfindung bezieht sich auf ein Verfahren zur Erzeugung einer stufenförmigen Struktur auf einem Substrat und insbesondere auf ein selbstjustierendes Verfahren zur Erzeugung einer stufenförmigen Struktur, wie beispielsweise eines Gateoxids für einen MOS-Transistor.

Bei einigen Anwendungen zur Herstellung von Halbleiterbauelementen kann es wünschenswert sein, stufenförmige Strukturen auszubilden. Eine solche Anwendung betrifft z.B. bestimmte MOS-Transistoren (MOS = Metall Oxid Semiconductor = Metall-Oxid-Halbleiter), wie z. B. einen LDMOS-Transistor (LDMOS = Laterally Diffused Metall Oxid Semiconductor). Es ist vorteilhaft, wenn das Dielektrikum einer Gateelektrode, das Gateoxid, an der Source-Seite eine geringere Dicke aufweist als an der Drain-Seite, so dass ein sogenanntes Stufengateoxid gebildet ist. Dieses Stufengateoxid verknüpft die Forderungen nach einem niedrigen Einschaltwiderstand Rₐₙ, d. h. einem möglichst dünnen Gateoxid, und nach einer hohen Spannungsfestigkeit, d. h. nach einem möglichst dicken Gateoxid.
Im Stand der Technik sind bereits Verfahren bekannt, mittels denen eine solche Oxidstufe hergestellt werden kann, und diese Verfahren werden als "Dual-Gox"-Prozesse beschrieben, bei denen nach der Herstellung der Oxidstufe eine Einstellung bzw. Justage der Gateelektrode auf diese Stufe erforderlich ist.

Dieses bekannte Verfahren ist nicht selbstjustierend, so dass sich Einschränkungen aufgrund der begrenzten Justiermöglichkeiten der verwendeten Belichtungsinstrumente ergeben. Der Nachteil der so hergestellten Gatestrukturen besteht darin, dass eine bestimmte Gatelänge nicht unterschritten und gewisse Toleranzen nicht erreicht werden können.

Ein weiterer Nachteil der herkömmlichen Verfahren besteht darin, dass eine unterschiedliche Dotierung von Source-Gebieten und Drain-Gebieten, wie es beispielsweise bei einem LDMOS-Transistor erforderlich ist, bei kurzen Gatestrukturen nur sehr schwierig oder auch gar nicht möglich ist.

In der US-A-4 803 179 wird ein Verfahren beschrieben, welches auf einer Erzeugung einer stufenförmigen Struktur auf einem Substrat beruht.

Ausgehend von diesem Stand der Technik liegt der vorliegenden Erfindung die Aufgabe zugrunde, ein verbessertes Verfahren zur Erzeugung einer stufenförmigen Struktur auf einem Substrat zu schaffen.

Diese Aufgabe wird durch ein Verfahren gemäß Anspruch 1 gelöst.

Gemäß der vorliegenden Erfindung wird die stufenförmige Struktur selbstjustiert hergestellt.

Die vorliegende Erfindung hat gegenüber herkömmlichen Prozessen den Vorteil, dass durch das selbstjustierende Verfahren kleinere Gatelängen und/oder geringere Toleranzen möglich sind als diese mit herkömmlichen Verfahren und der entsprechend vorhandenen Lithographieverfahren erreichbar sind.

Ein weiterer Vorteil der vorliegenden Erfindung besteht darin, dass diese eine unterschiedliche Dotierung der Source-Gebiete und der Drain-Gebiete, wie es z. B. bei einem LDMOS-Transistor erforderlich ist, auch bei sehr kurzen Gate-Strukturen, ermöglicht.

Bevorzugte Weiterbildungen der vorliegenden Erfindung sind in den Unteransprüchen definiert.

Nachfolgend werden anhand der beiliegenden Zeichnungen bevorzugte Ausführungsbeispiele der vorliegenden Erfindung näher erläutert. Es zeigen:
Fig. 1A bis 1M ein erstes Ausführungsbeispiel des erfindungsgemäßen Verfahrens; und
Fig. 2A bis 2M ein zweites Ausführungsbeispiel des erfindungsgemäßen Verfahrens.

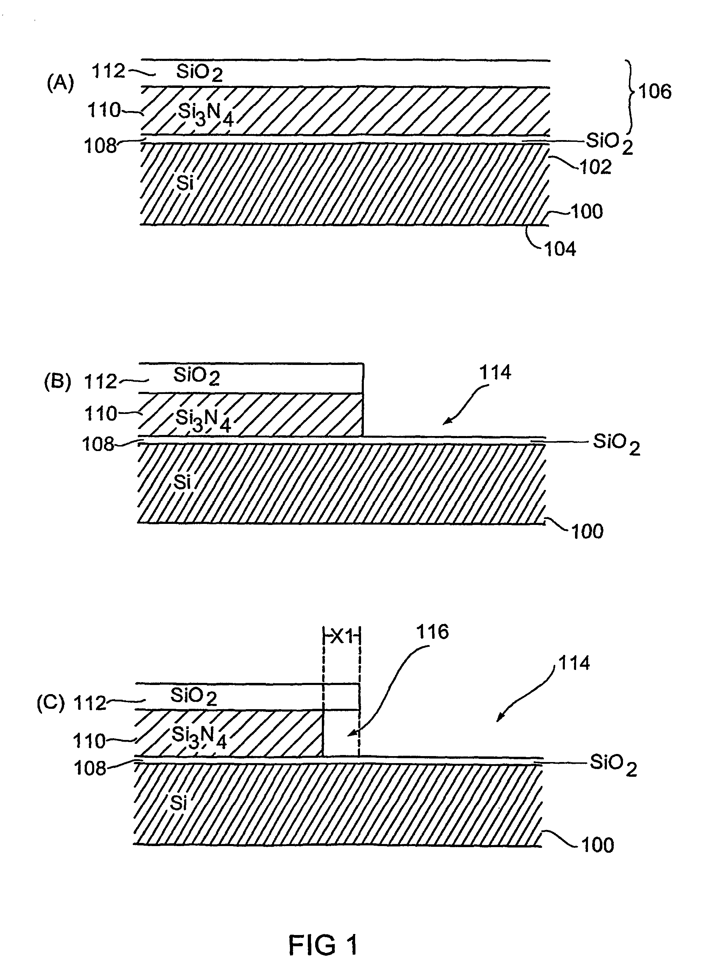

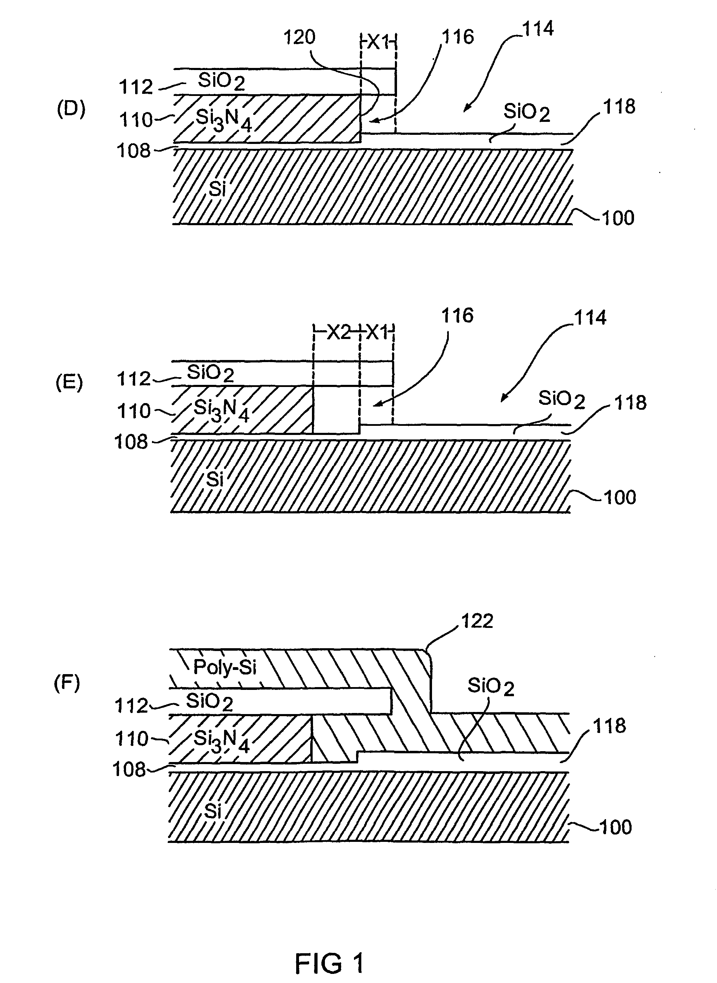

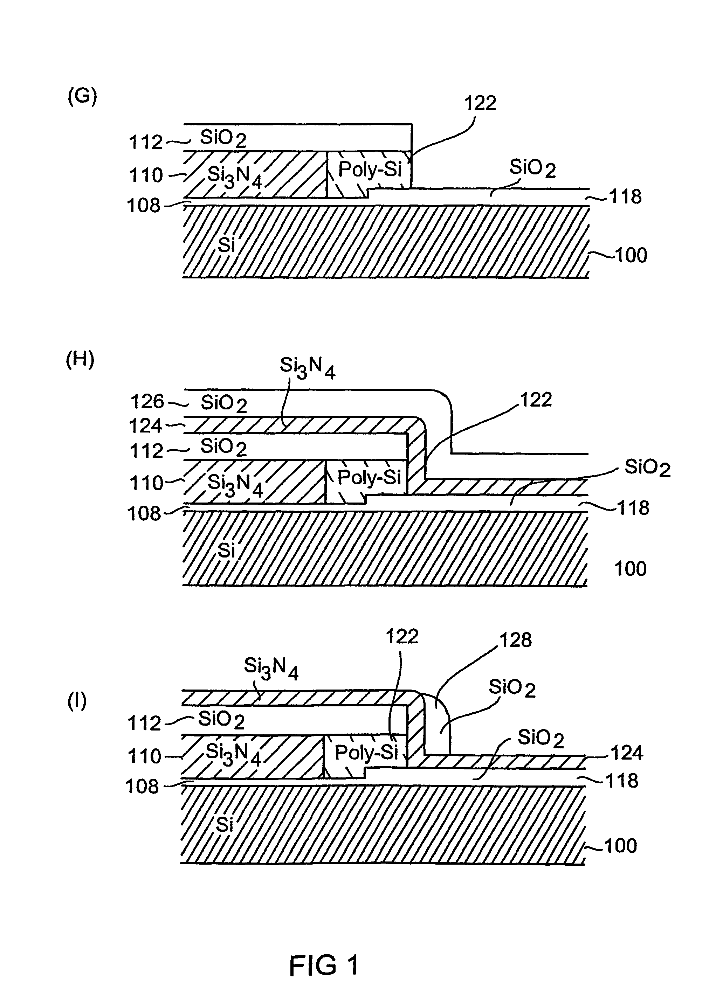

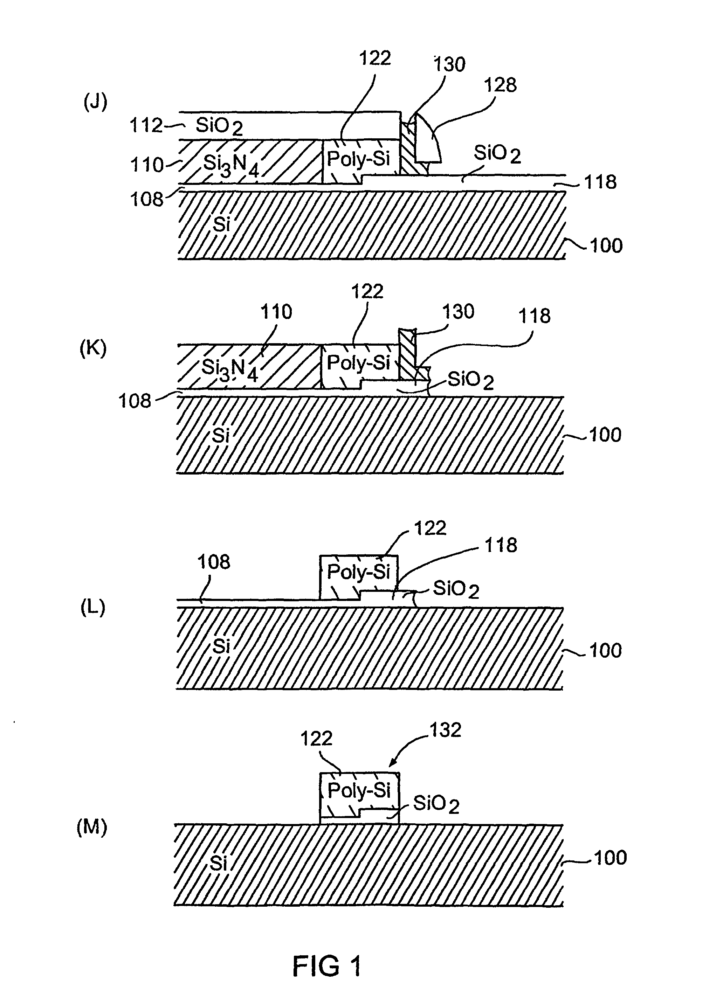

Anhand der Fig. 1 wird nun erstes, bevorzugtes Ausführungsbeispiel der vorliegenden Erfindung näher erläutert, wobei anhand der Fig. 1A bis 1M die verschiedenen Prozessschritte gemäß diesem bevorzugten Ausführungsbeispiel näher erläutert werden.

In Fig. 1A ist eine Halbleiterstruktur dargestellt, welche ein Substrat 100 umfasst, das eine erste Hauptoberfläche 102 sowie eine zweite Hauptoberfläche 104 aufweist. Auf der ersten Hauptoberfläche 102 des Substrats 100, welches bei dem dargestellten Ausführungsbeispiel ein Siliziumsubstrat ist, wird eine Schichtfolge 106 erzeugt, die eine erste Oxidschicht 108, die auf dem Substrat 100 angeordnet ist, eine auf der ersten Oxidschicht 108 angeordnete Nitridschicht 110 und eine auf der Nitridschicht 110 angeordnete zweite Oxidschicht 112 umfasst. Bei dem dargestellten Ausführungsbeispiel sind die Oxidschichten 108 und 112 Siliziumdioxidschichten und die Nitridschicht 110 ist eine Siliziumnitridschicht. In Fig. 1A ist das auf dem Ausgangsmaterial (Substrat) aufgebrachte Siliziumoxid/Siliziumnitrid/Siliziumoxid-Sandwich 106 dargestellt.

In einem nachfolgenden Prozessschritt wird die zweite bzw. obere Oxidschicht 112 und die erste Nitridschicht 110 unter Verwendung eines Lithographieschritts und einer anschließenden Ätzung strukturiert, wodurch sich die in Fig. 1B dargestellte Struktur ergibt, bei der ein Abschnitt 114 der ersten Oxidschicht freigelegt ist, so dass in diesem Bereich die dem Substrat 100 abgewandte Oberfläche der ersten Oxidschicht 108 freiliegt.

Anschließend wird die erste Nitridschicht 110 selektiv nasschemisch zurückgeätzt, um einen Teil der Nitridschicht unter der zweiten Oxidschicht 112 und über der ersten Oxidschicht 108 zu entfernen. Hierdurch wird die Länge eines ersten Bereichs des zu erzeugenden Gateoxids eingestellt. Bei dem dargestellten Ausführungsbeispiel wird der dickere Abschnitt der zu erzeugenden stufenförmigen Gateoxidstruktur hierdurch eingestellt. Das nasschemische selektive Ätzen erfolgt z.B. mittels heißer Phosphorsäure (∼ 80% H₃PO₄, T ∼ 155°C) für eine Zeitdauer von z.B. 25 Minuten.

In Fig. 1C ist die sich ergebende Struktur nach dem Ätzen der Nitridschicht 110 gezeigt. Wie zu erkennen ist, wurde unter der zweiten Oxidschicht 112 ein Bereich 116 freigelegt, in dem die Nitridschicht 110 zurückgeätzt wurde. Mit X1 ist die Länge des ersten Bereichs der zu erzeugenden Stufenstruktur bezeichnet.

In einem nachfolgenden Schritt wird eine Oxidation durchgeführt, um die Dicke der ersten Oxidschicht 108 im freigelegten Bereich 114 sowie im Bereich 116 zu erhöhen. Das Ergebnis dieses Verfahrensschritts ist in Fig. 1D gezeigt und wie zu erkennen ist, wurde die Oxidschicht 108 im Bereich 114 und in Bereich 116 gegenüber ihrer ursprünglichen Dicke vergrößert, und in diesem Bereich ist die Oxidschicht mit dem Bezugszeichen 118 versehen. Aufgrund der durchgeführten Oxidation kann es vorkommen, dass an einem Wandbereich 120 der Nitridschicht 110 ein Oxid (SiOx) entsteht, welches durch eine sehr kurze Oxidätzung entfernt werden muss.

Anschließend erfolgt erneut eine selektive nasschemische Zurückätzung der Nitridschicht 110, um einen weiteren Teil der Nitridschicht unter der zweiten Oxidschicht 112 und über der ersten Oxidschicht 108 zu entfernen. Hierdurch wird die Länge des Bereichs mit einem dünneren Gateoxid eingestellt. Wie auch schon bei dem ersten nasschemischen Ätzschritt der Nitridschicht 110 erfolgt hier das Ätzen z.B. mittels heißer Phosphorsäure (∼ 80% H₃PO₄, T ∼ 155°C) mit einer Ätzrate von 4 nm/min bei einer Zeitdauer von etwa 25 Minuten.

In Fig. 1E ist die sich ergebende Struktur gezeigt. Wie zu erkennen ist, wurde durch den nasschemischen Ätzvorgang der freigelegte Bereich 116 unter der Oxidschicht 112 vergrößert, wobei mit X2 die Länge dieses neuen Bereichs angegeben ist. In Fig. 1E ist die stufenförmige Struktur des Oxids 108, 118 bereits zu erkennen.

Nachfolgend zu dem weiteren Ätzschritt erfolgt eine konforme Abscheidung einer Polysiliziumschicht 122 auf die gesamte Oberfläche der Struktur, so dass sich die in Fig. 1F gezeigte Struktur ergibt. Die Polysiliziumschicht 122 wird anschließend anisotrop und selektiv zu den Siliziumoxidschichten zurückgeätzt, so dass sich die in Fig. 1G gezeigte Struktur ergibt, bei der das Polysilizium lediglich im Bereich 116 verblieben ist. An dieser Stelle des Herstellungsprozesses besteht nun die Möglichkeit einer Implantation, wodurch das in Fig. 1G rechts von der zukünftigen Gatestruktur liegende Gebiet (unterhalb der dicken Oxidschicht) dotiert wird, das in der Fig. 1G links von der zukünftigen Gatestruktur, also unter der verbliebenen Nitridschicht 110 liegende Gebiet, im Substrat jedoch nicht.

In einem weiteren Verfahrensschritt wird eine weitere Siliziumnitridschicht 124 sowie eine weitere Oxidschicht 126 ganzflächig auf der Struktur konform abgeschieden, so dass sich die in Fig. 1 H gezeigte Struktur ergibt.

Dann wird die weitere Siliziumoxidschicht 126 anisotrop und selektiv zu dem Siliziumnitrid zurückgeätzt, so dass an der Topologiestufe ein Oxidrest 128 zurückbleibt, wie dies in Fig. 1I gezeigt ist. Die Topologiestufe hat sich durch das anfängliche Freilegen des Abschnitts 114 und die nachfolgende Verfüllung des Bereichs 116 mit dem Polysilizium ergeben.

Hieran anschließend wird auch die Siliziumnitridschicht 124 selektiv zu dem Siliziumoxid geätzt, und zusätzlich zu dem Oxidrest 128 verbleibt an der Topologiestufe ein Nitridrest 130, wie dies in Fig. 1J gezeigt ist.

Das Siliziumoxid, also die Schichten 112 und 118, sowie der Rest 128 werden dann ganzflächig und selektiv zu dem Siliziumnitrid und nach Möglichkeit selektiv zu dem Silizium geätzt, so dass sich die in Fig. 1K dargestellte Struktur ergibt.

Nachfolgend wird die Nitridschicht 110 und der Nitridrest 130 selektiv geätzt, so dass sich die in Fig. 1L gezeigte Struktur ergibt, bei der anschließend, soweit erforderlich, die Oxidschicht 108, 118 anisotrop und selektiv zu dem Silizium des Substrats geätzt wird, so dass sich die abschließende stufenförmige Struktur 132 ergibt, wie sie in Fig. 1M dargestellt ist.

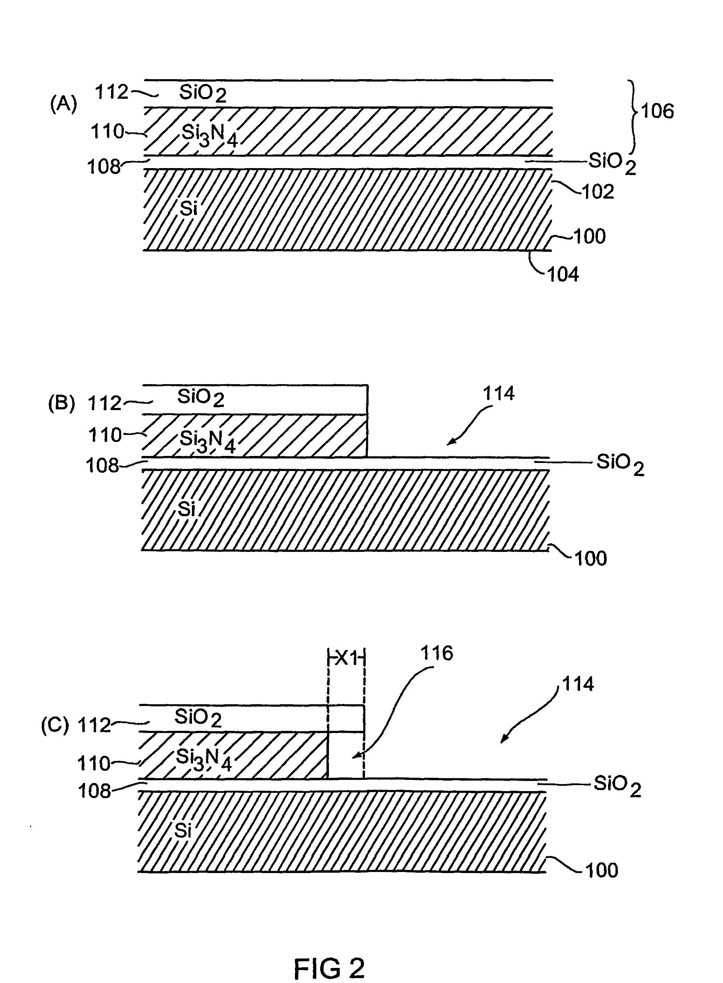

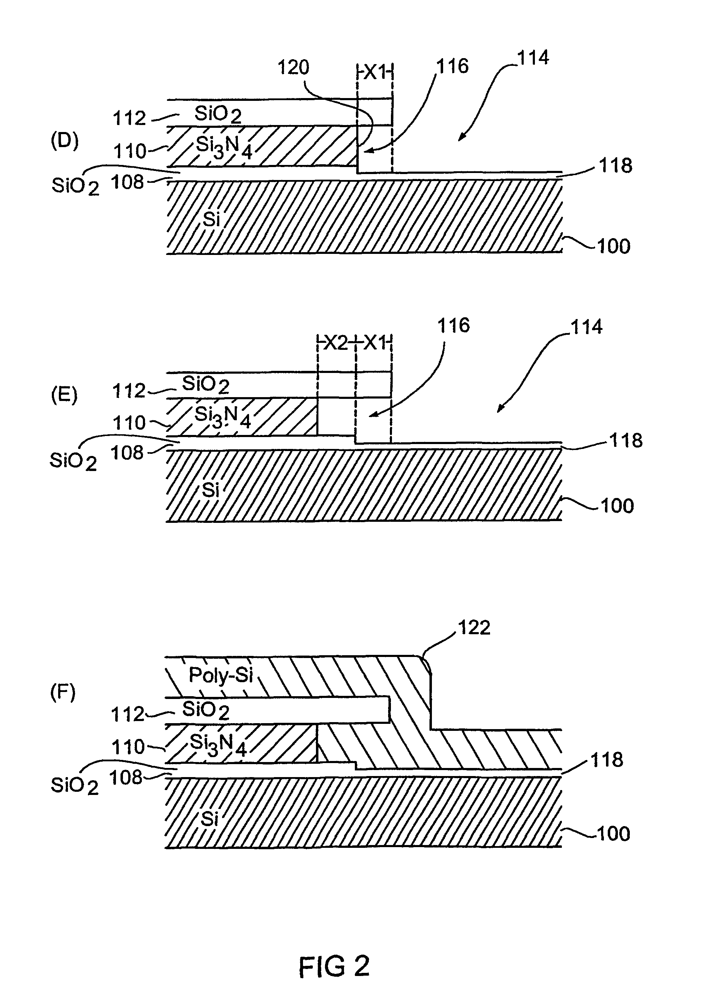

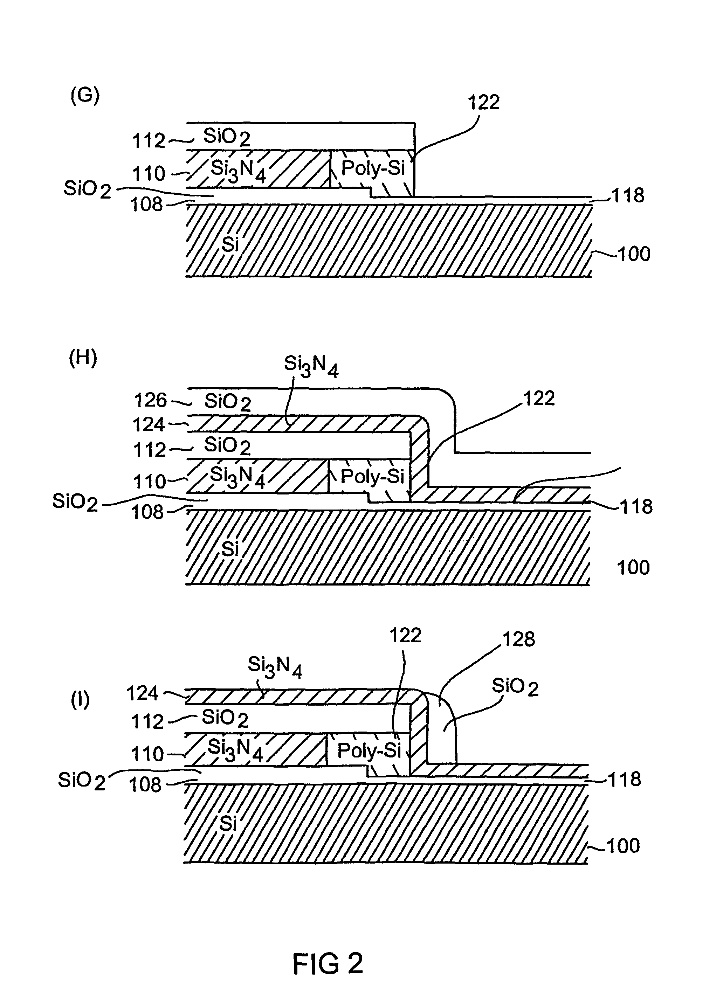

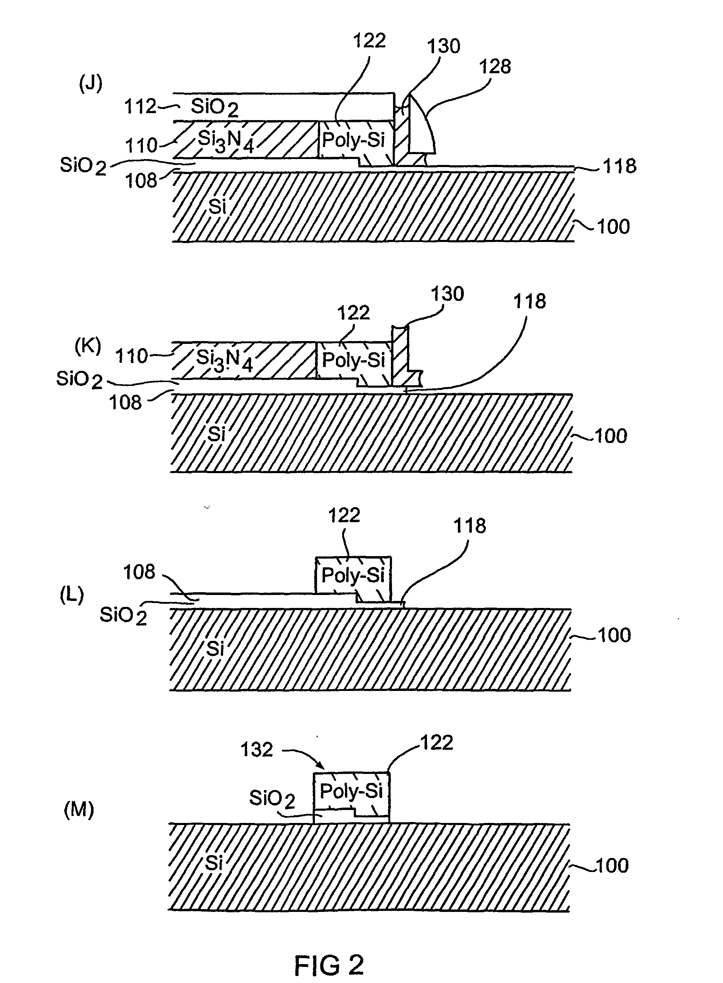

Anhand der Fig. 2 wird nachfolgend ein zweites bevorzugtes Ausführungsbeispiel des erfindungsgemäßen Verfahrens näher erläutert, wobei bei der nachfolgenden Beschreibung der einzelnen Verfahrensschritte diejenigen Verfahrensschritte nicht erneut beschrieben werden, die bereits anhand der Fig. 1 beschrieben wurden.

Die in den Fig. 2A bis 2C beschriebenen Verfahrensschritte entsprechen den anhand der Fig. 1A bis 1C beschriebenen Verfahrensschritte, und auch die Struktur, die sich nach denselben ergibt (siehe Fig. 2C), entspricht denjenigen, wie sie sich nach den entsprechenden Verfahrensschritten gemäß Fig. 1A bis 1C ergibt.

Das Verfahren gemäß dem zweiten Ausführungsbeispiel unterscheidet sich gegenüber dem ersten Ausführungsbeispiel dahingehend, dass nach dem erstmaligen Ätzen der Siliziumnitridschicht 110 die Oxidschicht 108, anders als im ersten Ausführungsbeispiel, bei dem dieselbe dicker gemacht wurde, nunmehr gedünnt wird. Wie in Fig. 2D zu erkennen ist, wurde das nach dem Ätzen der Siliziumnitridschicht 110 nicht mehr durch das Siliziumnitrid bedeckte Oxid der ersten Oxidschicht 108 gedünnt, so dass die gedünnte Oxidschicht 118 entstanden ist. Vorzugsweise wird aus prozesstechnischen Gründen die Dünnung der Oxidschicht 108 derart erfolgen, dass die Oxidschicht 108 im Bereich 114 und 116 zunächst vollständig entfernt wird und anschließend eine neue Oxidschicht durch einen Oxidationsvorgang erzeugt wird, deren Dicke kleiner ist als die Dicke der ursprünglichen Oxidschicht 108. Eine aufgrund des Oxidationsvorgangs an der Nitridseitenwand 120 entstehendes Nitridoxid (NiOx) wird anschließend mit einer sehr kurzen Oxidätzung entfernt.

Anders als bei dem anhand der Fig. 1 beschriebenen Ausführungsbeispiel wird gemäß Fig. 2 nun zunächst der dünnere Bereich der stufenförmigen Struktur des Gateoxids gebildet und nach diesem Schritt wird die Siliziumnitridschicht 110 erneut selektiv nasschemisch zurückgeätzt, wodurch die Länge X2, jetzt des dickeren Bereichs der stufenförmigen Struktur, eingestellt wird.

Die verbleibenden Schritte zur Fertigstellung der Struktur, die anhand der Fig. 2F bis 2M gezeigt sind, entsprechen den anhand der Fig. 1F bis 1M beschriebenen Schritte, und hinsichtlich einer näheren Erläuterung dieser Schritte wird auf die vorhergehende Beschreibung der Fig. 1F bis 1M verwiesen.

Ähnlich wie beim ersten Ausführungsbeispiel kann auch beim zweiten Ausführungsbeispiel nach dem Erzeugen der Stufenstruktur (siehe Fig. 2G) an dieser Stelle des Herstellungsprozesses eine Implantation erfolgen, wodurch das in Fig. 2G rechts von der zukünftigen Gatestruktur liegende Gebiet (unterhalb der dünneren Oxidschicht) dotiert wird, das in der Fig. 2G links von der zukünftigen Gatestruktur, also unter der verbliebenen Nitridschicht 110 liegende Gebiet, im Substrat jedoch nicht. Somit erfolgt, anders als im ersten Ausführungsbeispiel (Fig. 1), bei dem zweiten Ausführungsbeispiel (Fig. 2), die Implantation im Bereich des dünneren Oxids und nicht im Bereich des dickeren Oxids.

Bei der obigen Beschreibung der bevorzugten Ausführungsbeispiele wurde ein Siliziumsubstrat 100 verwendet und die Oxidschichten sind SiO₂-Schichten. Die Nitridschichten sind Si₃N₄-Schichten. Die vorliegende Erfindung ist nicht auf diese Materialien beschränkt, sondern es können auch andere geeignete Materialien zur Herstellung der stufenförmigen Struktur eingesetzt werden, wie z. B. organische Materialien. Ferner kann das Polysilizium-Gate durch Wolfram ersetzt werden. Anstelle eines Siliziumsubstrats kann auch ein Siliziumkarbidsubstrat verwendet werden.

Der Vorteil der vorliegenden Erfindung besteht darin, dass diese ein selbstjustierendes Verfahren zur Herstellung der stufenförmigen Struktur 132 (siehe Fig. 1M bzw. Fig. 2M) schafft, wobei sich durch das erfindungsgemäße Verfahren sehr kurze Gatestrukturen erreichen lassen. Hinsichtlich der Größenordung der Gatestruktur existieren keine theoretischen Begrenzungen. Gemäß einem Ausführungsbeispiel liegt die Gatelänge zwischen 0,1µm und 0,5µm, wobei der Anteil des dünnen Bereichs zwischen 20% und 80% der Gesamtlänge beträgt.

Obwohl das obige Verfahren anhand der Herstellung einer Gateoxidschicht für einen MOS-Transistor beschrieben wurde, ist die vorliegende Erfindung nicht hierauf beschränkt, sondern findet vielmehr ihre Anwendung bei allen Halbleiterstrukturen, bei denen stufenförmige Strukturen erforderlich sind.

Wie oben beschrieben wurde, wird die Siliziumnitridschicht 110 zweimal nasschemisch selektiv geätzt, wobei hier vorzugsweise heiße Phosphorsäure (∼ 80% H₃PO₄, T ∼ 155°C) als Ätzmittel mit einer Ätzrate von 4 nm/min zum Einsatz kommt. Bei den dargestellten Ausführungsbeispielen werden für die zwei Bereiche der stufenförmigen Struktur gleiche Längen von etwa 0,1 µm gewählt, was durch eine Ätzdauer von etwa 25 Minuten erreicht wird. Allgemein kann das nasschemische Ätzen unter Verwendung von heißer Phosphorsäure (∼ 80% H₃PO₄, T ∼ 155°C) mit einer Ätzrate von 1 nm/min bis 20 nm/min für eine Zeitdauer von 1 Minute bis 400 Minuten durchgeführt werden. Anstelle der Polysiliziumschicht kann eine andere elektrisch leitende Schicht verwendet werden.

Die vorliegende Erfindung ist nicht auf die oben beschriebenen Herstellungsschritte beschränkt. Abhängig von den zu erzeugenden Strukturen können einzelne Schritte modifiziert oder weggelassen werden, oder andere Schritte eingefügt werden.

Die vorliegende Erfindung ist nicht auf die oben beschriebenen Ausführungsbeispiele beschränkt. Zusätzlich zu den beschriebenen Strukturen können durch das erfindungsgemäße Verfahren auch Strukturen mit mehr als einer Stufe erzeugt werden. In diesem Fall erfolgt ein mehrmaliges Ätzen der Nitridschicht 110 sowie eine mehrmalige Oxidation (Fig. 1) bzw. ein mehrmaliges Dünnen (Fig. 2) der Oxidschicht, um so mehrere Stufen zu erzeugen.

## Patentansprüche

1. Verfahren zur Erzeugung einer stufenförmigen Struktur (132) auf einem Substrat (100), wobei die stufenförmige Struktur (132) zumindest einen ersten Abschnitt (X1) mit einer ersten Dicke und einen zweiten Abschnitt (X2) mit einer zweiten Dicke umfasst, mit folgenden Schritten:
(a) Aufbringen einer Schichtfolge (106) aus einer ersten Oxidschicht (108), einer ersten Nitridschicht (110) und einer zweiten Oxidschicht (112) auf das Substrat (100);
(b) Entfernen eines Abschnitts der zweiten Oxidschicht (112) und eines Abschnitts der ersten Nitridschicht (110), um einen Abschnitt (114) der ersten Oxidschicht (108) freizulegen;
(c) Entfernen eines Teils der ersten Nitridschicht (110) über der ersten Oxidschicht (108) und unter der zweiten Oxidschicht (112), um den ersten Bereich (X1) der stufenförmigen Struktur (132) festzulegen;
(d) Verändern der Dicke der ersten Oxidschicht (118) zumindest in dem im Schritt (c) festgelegten ersten Bereich (X1), um die erste Dicke desselben festzulegen; und
(e) Entfernen eines weiteren Teils der ersten Nitridschicht (110) über der ersten Oxidschicht (108) und unter der zweiten Oxidschicht (112), um den zweiten Bereich (X2) der stufenförmigen Struktur (132) festzulegen.

2. Verfahren nach Anspruch 1, mit folgendem Schritt:
(f) Freilegen der stufenförmigen Struktur (132).

3. Verfahren gemäß Anspruch 1 oder 2, bei dem der Schritt (d) den Schritt des Erhöhens der Dicke der ersten Oxidschicht (108) zumindest in dem ersten Bereich (X1) umfasst.

4. Verfahren gemäß Anspruch 3, bei dem der Schritt des Erhöhens eine Oxidation umfasst.

5. Verfahren gemäß Anspruch 1 oder 2, bei dem der Schritt (d) den Schritt des Dünnens der ersten Oxidschicht (108) zumindest in dem ersten Bereich (X1) umfasst.

6. Verfahren gemäß Anspruch 5, bei dem der Schritt des Dünnens das Ätzen der ersten Oxidschicht (108) umfasst.

7. Verfahren gemäß Anspruch 5, bei dem der Schritt des Dünnens folgende Schritte umfasst:
Entfernen der ersten Oxidschicht (108) zumindest in dem ersten Bereich (X1); und
Aufbringen einer neuer Oxidschicht (118) zumindest in dem ersten Bereich (X1) mit einer Dicke, die kleiner ist als die Dicke der ersten Oxidschicht (108).

8. Verfahren gemäß einem der Ansprüche 1 bis 7, bei dem die Schritte (c) und (e) ein selektives nasschemisches Ätzen der ersten Nitridschicht (110) umfassen.

9. Verfahren gemäß Anspruch 8, bei dem das nasschemische Ätzen unter Verwendung von heißer Phosphorsäure (∼ 80% H₃PO₄, T ∼ 155°C) mit einer Ätzrate von 1 nm/min bis 20 nm/min für eine Zeitdauer von 1 Minute bis 400 Minuten erfolgt.

10. Verfahren gemäß einem der Ansprüche 1 bis 9, bei dem der Schritt (b) folgende Schritte umfasst:
(b.1) Aufbringen und Strukturieren eines Photoresists auf der Schichtfolge (106), um freizulegende Bereiche festzulegen; und
(b.2) Ätzen der zweiten Oxidschicht (112) und der ersten Nitridschicht (110) bis zu der ersten Oxidschicht (108).

11. Verfahren gemäß einem der Ansprüche 1 bis 10, mit folgenden Schritten nach dem Schritt (e):
Abscheiden einer elektrisch leitenden Schicht (122) in dem ersten Bereich (X1) und in dem zweiten Bereich (X2).

12. Verfahren gemäß einem der Ansprüche 1 bis 11, mit folgenden Schritten nach dem Schritt (e):
Durchführen einer Implantation bezüglich des Substrats (100), um in dem nur durch die erste Oxidschicht (118) bedeckten Abschnitt des Substrats (100) einen dotierten Bereich zu bilden.

13. Verfahren gemäß Anspruch 11 oder 12, bei dem die elektrisch leitende Schicht (122) konform auf dem Substrat (100) abgeschieden wird und anschließend anisotrop und selektiv zu den Oxidschichten (112, 118) geätzt wird.

14. Verfahren gemäß einem der Ansprüche 11 bis 13, bei dem der Schritt (f) folgende Schritte umfasst:
(f.1) Abscheiden einer zweiten Nitridschicht (124);
(f.2) Abscheiden einer dritten Oxidschicht (126);
(f.3) Entfernen der dritten Oxidschicht (126) selektiv zu der zweiten Nitridschicht (124), so dass an einer Stufe, die durch das Freilegen der ersten Oxidschicht im Schritt (b) gebildet wurde, ein Oxidrest (128) verbleibt;
(f.4) Entfernen der zweiten Nitridschicht (124) selektiv zu der zweiten Oxidschicht (112), so dass an der Stufe ein Nitridrest (130) verbleibt;
(f.5) Entfernen der Oxidschichten (112, 118, 128) selektiv zu den Nitridschichten und selektiv zu dem Substrat;
(f.6) Entfernen der Nitridschichten (110, 130); und
(f.7) Entfernen der ersten Oxidschicht (108, 118) außerhalb des ersten und des zweiten Bereichs (X1, X2).

15. Verfahren gemäß einem der Ansprüche 1 bis 14, bei dem die stufenförmige Struktur (132) ein Gateoxid eines MOS-Transistors ist.

16. Verfahren gemäß einem der Ansprüche 1 bis 15, bei dem die Oxidschichten (108, 118, 126, 128) SiO₂-Schichten sind, bei dem die Nitridschichten (110, 124, 130) Si₃N₄-Schichten sind, bei dem das Substrat (100) ein Si-Substrat ist, und bei dem die elektrisch leitende Schicht (122) eine Polysiliziumschicht ist.

17. Verfahren nach einem der Ansprüche 1 bis 16, bei dem im Schritt (d) die Dicke der ersten Oxidschicht mehrfach verändert wird, um eine Struktur mit einer Mehrzahl von Stufen zu erzeugen.

## Claims

1. Method for creating a stepped structure (132) on a substrate (100), wherein the stepped structure (132) includes at least a first portion (X1) with a first thickness and a second portion (X2) with a second thickness, comprising:
(a) applying a layer sequence (106) of a first oxide layer (108), a first nitride layer (110), and a second oxide layer (112) to the substrate (100);
(b) removing a portion of the second oxide layer (112) and a portion of the first nitride layer (110) to expose a portion (114) of the first oxide layer (108);
(c) removing a part of the first nitride layer (110) above the first oxide layer (108) and below the second oxide layer (112) to establish the first region (X1) of the stepped structure (132);
(d) changing the thickness of the first oxide layer (118) at least in the first region (X1) established in step (c) to establish the first thickness thereof; and
(e) removing a further part of the first nitride layer (110) above the first oxide layer (108) and below the second oxide layer (112) to establish the second region (X2) of the stepped structure (132).

2. Method of claim 1, comprising:
(f) exposing the stepped structure (132).

3. Method of claim 1 or 2, wherein the step (d) includes the step of increasing the thickness of the first oxide layer (108) at least in the first region (X1).

4. Method of claim 3, wherein the step of increasing includes an oxidation.

5. Method of claim 1 or 2, wherein the step (d) includes the step of thinning the first oxide layer (108) at least in the first region (X1).

6. Method of claim 5, wherein the step of thinning includes the etching of the first oxide layer (108).

7. Method of claim 5, wherein the step of thinning includes the following steps:
removing the first oxide layer (108) at least in the first region (X1); and
applying a new oxide layer (118) at least in the first region (X1) with a thickness smaller than the thickness of the first oxide layer (108).

8. Method of one of claims 1 to 7, wherein the steps (c) and (e) include selective wet-chemical etching of the first nitride layer (110).

9. Method of claim 8, wherein the wet-chemical etching takes place using hot phosphoric acid (∼ 80% H₃PO₄, T ∼ 155°C) at an etching rate of 1 nm/min to 20 nm/min for a period of time of 1 minute to 400 minutes.

10. Method of one of claims 1 to 9, wherein the step (b) includes the following steps:
(b.1) applying and structuring a photoresist on the layer sequence (106) to establish regions to be exposed; and
(b.2) etching the second oxide layer (112) and the first nitride layer (110) up to the first oxide layer (108).

11. Method of one of claims 1 to 10, comprising after step (e):
depositing an electrically conducting layer (122) in the first region (X1) and in the second region (X2).

12. Method of one of claims 1 to 11, comprising after step (e):
performing an implant with respect to the substrate (100) to form a doped region in the portion of the substrate (100) only covered by the first oxide layer (118).

13. Method of claim 11 or 12, wherein the electrically conducting layer (122) is conformly deposited on the substrate (100) and then etched anisotropically and selectively to the oxide layers (112, 118).

14. Method of one of claims 11 to 13, wherein the step (f) comprises:
(f.1) depositing a second nitride layer (124);
(f.2) depositing a third oxide layer (126);
(f.3) removing the third oxide layer (126) selectively to the second nitride layer (124), so that an oxide remainder (128) remains at a step formed by the exposing of the first oxide layer in step (b);
(f.4) removing the second nitride layer (124) selectively to the second oxide layer (112), so that the nitride remainder (130) remains at the step;
(f.5) removing the oxide layers (112, 118, 128) selectively to the nitride layers and selectively to the substrate;
(f.6) removing the nitride layers (110, 130); and
(f.7) removing the first oxide layer (108; 118) outside the first and second regions (X1, X2).

15. Method of one of claims 1 to 14, wherein the stepped structure (132) is a gate oxide of a MOS transistor.

16. Method of one of claims 1 to 15, wherein the oxide layers (108, 118, 126, 128) are SiO₂ layers, wherein the nitride layers (110, 124, 130) are Si₃N₄ layers, wherein the substrate (100) is a Si substrate, and wherein the electrically conducting layer (122) is a polysilicon layer.

17. Method of one of claims 1 to 16, wherein in step (d) the thickness of the first oxide layer is repeatedly changed to create a structure with a plurality of steps.

## Revendications

1. Procédé de production d'une structure (132) étagée sur un substrat (100), la structure (132) étagée comprenant au moins une première partie (X1) ayant une première épaisseur et une deuxième partie (X2) ayant une deuxième épaisseur, comportant les stades qui consistent :
(a) à déposer une succession (106) de couches constituées d'une première couche (108) d'oxyde, d'une première couche (110) de nitrure et d'une deuxième couche (112) d'oxyde sur le substrat (100);
(b) à éliminer une partie de la deuxième couche (112) d'oxyde et une partie de la première couche (110) de nitrure, pour mettre à nue une partie (114) de la première couche (108) d'oxyde;
(c) à éliminer une partie de la première couche (110) de nitrure, sur la première couche (108) d'oxyde et sous la deuxième couche (112) d'oxyde, pour définir la première partie (X1) de la structure (132) étagée;
(d) à modifier l'épaisseur de la première couche (118) d'oxyde au moins dans la première partie (X1) définie au stade (c), pour en définir la première épaisseur; et
(e) à éliminer une autre partie de la première couche (110) de nitrure, sur la première couche (108) d'oxyde et sous la deuxième couche (112) d'oxyde, pour définir la deuxième partie (X2) de la structure (132) étagée.

2. Procédé suivant la revendication 1, qui comporte l'étape qui consiste :
(f) à mettre à nue la structure (132) étagée.

3. Procédé suivant la revendication 1 ou 2, dans lequel le stade (d) comprend le stade d'augmentation de l'épaisseur de la première couche (108) d'oxyde au moins dans la première partie (X1).

4. Procédé suivant la revendication 3, dans lequel le stade d'augmentation comprend une oxydation.

5. Procédé suivant la revendication 1 ou 2, dans lequel le stade (d) comprend la stade d'amincissement de la première couche (108) d'oxyde au moins dans la première partie (X1).

6. Procédé suivant la revendication 5, dans lequel le stade d'amincissement comprend l'attaque de la première couche (108) d'oxyde.

7. Procédé suivant la revendication 5, dans lequel le stade d'amincissement comprend les stades suivants qui consistent :
à éliminer la première couche (108) d'oxyde au moins dans la première partie (X1); et
à déposer une nouvelle couche (118) d'oxyde au moins dans la première partie (X1) d'une épaisseur qui est inférieure à l'épaisseur de la première couche (108) d'oxyde.

8. Procédé suivant l'une des revendications 1 à 7, dans lequel les stades (c) et (e) comprennent une attaque chimique sélective en voie humide de la première couche (110) de nitrure.

9. Procédé suivant la revendication 8, dans lequel l'attaque chimique en voie humide s'effectue en utilisant de l'acide phosphorique chaud (H₃PO₄ à environ 80%, T à environ 155°C) à une vitesse d'attaque comprise entre 1 nm/ min et 20 nm / min pendant une durée de 1 minute à 400 minutes.

10. Procédé suivant l'une des revendications 1 à 9, dans lequel le stade (d) comprend les stades suivants qui consistent :
(b.1) à déposer et structurer, un photorésist sur la succession (106) de couches pour définir des parties mises à nues; et
(b.2) à attaquer la deuxième couche (112) d'oxyde et la première couche (110) de nitrure jusqu'à la première couche (108) d'oxyde.

11. Procédé suivant l'une des revendications 1 à 10, comprenant après le stade (e), les stades suivant qui consistent :
à déposer une couche (122) conductrice d'électricité dans la première partie (X1) et dans la deuxième partie (X2).

12. Procédé suivant l'une des revendications 1 à 11, comprenant après le stade (e), les stades suivant qui consistent :
à effectuer une implantation pour ce qui concerne le substrat (100), pour former une partie dopée seulement dans la partie du substrat (100) qui est revêtu de la première couche (118) d'oxyde.

13. Procédé suivant la revendication 11 ou 12, dans lequel on dépose la couche (122) conductrice de l'électricité de manière conforme sur le substrat (100) et on l'attaque ensuite de manière anisotrope et sélective par rapport aux couches (112, 118) d'oxyde.

14. Procédé suivant l'une des revendications 11 à 13, dans lequel le stade (f) comprend les stades suivants qui consistent :
(f.1) à déposer une deuxième couche (124) de nitrure;
(f.2) à déposer une troisième couche (126) de nitrure;
(f.3) à éliminer la troisième couche (126) d'oxyde sélectivement par rapport à la deuxième couche (124) de nitrure de manière à laisser subsister sur un étage, qui a été formé par la mise à nue de la première couche d'oxyde au stade (b), un reste (128) d'oxyde;
(f.4) à éliminer la deuxième couche (124) de nitrure sélectivement par rapport à la deuxième couche (112) d'oxyde de manière à laisser sur l'étage un reste (130) de nitrure;
(f.5) à éliminer les couches (112, 118, 128) d'oxyde sélectivement par rapport aux couches de nitrure et sélectivement par rapport au substrat;
(f.6) à éliminer les couches (110, 130) de nitrure; et
(f.7) à éliminer la première couche (108, 118) d'oxyde à l'extérieur de la première et de la deuxième parties (X1, X2).

15. Procédé suivant l'une des revendications 1 à 14, dans lequel la structure (132) étagée est un oxyde de grille d'un transistor MOS.

16. Procédé suivant l'une des revendications 1 à 15, dans lequel les couches (108, 118, 126, 128) d'oxyde sont des couches de SiO₂, dans lequel les couches (110, 124, 130) de nitrure sont des couches de Si₃ N₄, dans lequel le substrat (100) est un substrat de Si, et dans lequel la couche (122) conductrice de l'électricité est une couche de polysilicium.

17. Procédé suivant l'une des revendications 1 à 16, dans lequel on modifie plusieurs fois au stade (d) l'épaisseur de la première couche d'oxyde pour produire une structure ayant une pluralité d'étages.
